# EUROPÄISCHE PATENTANMELDUNG

(11) **EP 1 217 666 A1**
(43) Veröffentlichungstag der Anmeldung: **26.06.2002**
(21) Anmeldenummer: 00811223.7
(22) Anmeldetag: 21.12.2000
(51) Int. Cl.: H01L 39/16

(54) **Resistiver Strombegrenzer**

(71) Anmelder: ABB RESEARCH LTD., 8050 Zürich (CH)
(72) Erfinder: Donzel, Lise, 5430 Wettingen (CH); Lakner, Martin, 5413 Birmenstorf (CH); Chen, Makan, 5405 Baden-Dättwil (CH); Paul, Willi, 5430 Wettingen (CH)
(74) Vertreter: ABB Patent Attorneys

(57) **Zusammenfassung**

In einem supraleitenden Strombegrenzer werden im Begrenzungsfall durch Verdampfen der Kühlflüssigkeit Schockwellen erzeugt, welche den Supraleiter schädigen können. Bei einem resistiven Strombegrenzer mit mehreren plattenförmigen Modulen (10,10') wird zwischen diesen zwecks Dämpfung der Modulvibrationen ein poröser, elektrisch isolierender Schwingungsdämpfer (22) vorgesehen, der auch die Zirkulation der Kühlflüssigkeit (21) erlaubt. Bevorzugt umfasst dieser eine Schüttung kleiner Partikel oder einen elastischen Körper.

## Beschreibung

### TECHNISCHES GEBIET

Die vorliegende Erfindung bezieht sich auf das Gebiet der angewandten Hochtemperatursupraleitung im Bereich der Stromversorgung. Sie betrifft einen resistiven Strombegrenzer gemäss dem Oberbegriff des Patentanspruchs 1.

### STAND DER TECHNIK

Hochtemperatursupraleiter finden beispielsweise Verwendung in supraleitenden Kurzschluss-Strombegrenzern für elektrische Verteil- oder Übertragungsnetze. Bei einem solchen Strombegrenzer wird ausgenutzt, dass ein Supraleiter bei entsprechend tiefer Temperatur seine Supraleitfähigkeit nur solange beibehält, als die Stromdichte eines ihn durchfliessenden Stromes unterhalb eines gewissen, als kritische Stromdichte bezeichneten Grenzwertes bleibt. Treten jedoch im entsprechenden Stromversorgungsnetzwerk Kurzschlüsse auf, wächst der Strom im Strombegrenzer zu einem den kritischen Wert übertreffenden Fehlerstrom an.

Auch andere supraleitende Bauteile wie Übertragungskabel oder Transformatoren weisen inhärent eine kritische Stromstärke (I_{c}) auf. Im Nennbetrieb leiten diese Bauteile einen Nennstrom I_{N}, welcher kleiner ist als der kritische Strom I_{c}, verlustfrei. Auf Grund von Transienten, welche durch Schaltnetzkomponenten wie Filterkreise oder grosse Verbraucher im Versorgungsnetz erzeugt werden, kann dieser Nennstrom aber kurzzeitig zu einem Überstrom anwachsen.

Vorrichtungen auf Hochtemperatursupraleiterbasis werden normalerweise in ein flüssiges Kühlmedium, der Einfachheit halber vorzugsweise flüssigen Stickstoff LN₂, welcher durch ein Kryostat genanntes Gefäss von der Umgebung thermisch isoliert wird, eingetaucht. Als Folge eines Fehler- oder Überstromes in einem supraleitenden Bauteil tritt der Supraleiter in den resistiven Zustand über, d.h. die am entsprechenden Abschnitt des Stromversorgungsnetzwerkes anliegende Spannung fällt zumindest kurzzeitig ganz (im Kurzschlussfall) oder teilweise am Supraleiter ab. Joulsche Wärme wird erzeugt, und der Supraleiter heizt sich unter Umständen sehr stark auf und erwärmt auch das ihn umgebende Kühlmedium. Besteht dieses aus flüssigem Stickstoff, so wird eine grosse Menge davon in kurzer Zeit verdampft, so dass im Kryostaten ein Überdruck entsteht und Druck- oder Schockwellen sich fast explosionsartig ausbreiten. Dadurch beginnt die Supraleitervorrichtung zu vibrieren und erleidet einen irreparablen mechanischen Schaden, beispielsweise durch Rissbildung in der Hochtemperatursupraleiterkeramik oder durch Ablösung einer Leiter- oder Trägerschicht.

In der Patentschrift DE 44 34 819 C1 ist ein resistiver supraleitender Strombegrenzer dargestellt, welcher mehrere elektrisch in Reihe geschaltete Module umfasst, die in einem Kryostaten nebeneinander angeordnet sind. Die einzelnen Module sind schichtartig aufgebaut und umfassen einen Isolator als Träger und beidseitig darauf aufgebrachte Leiterverbunde. In der DE 196 31 439 C1 ist ein induktiver Strombegrenzer dargestellt. Dieser besteht aus übereinandergestapelten hohlzylindrischen supraleitenden Bauteilen, welche mit einem schwingungsdämpfenden Gewebe wie Watte oder Filz umwickelt sind.

### DARSTELLUNG DER ERFINDUNG

Aufgabe der vorliegenden Erfindung ist es, bei einem resistiven Strombegrenzer der eingangs genannten Art die mechanische Belastung der Supraleiter zu verringern und deren Verfügbarkeit zu erhöhen. Diese Aufgabe wird durch einen resistiven Strombegrenzer mit den Merkmalen des Patentanspruchs 1 gelöst.

Kern der Erfindung ist es, zwischen den Modulen des Strombegrenzers einen Schwingungsdämpfer vorzusehen. Dieser ist porös, elektrisch isolierend und steht in unmittelbarem Kontakt mit den Modulen. Der Schwingungsdämpfer ist im Betrieb von einer Kühlflüssigkeit umgeben beziehungsweise durchdrungen. Durch den erfindungsgemässen Schwingungsdämpfer werden Vibrationen der Module wirksam gedämpft, wodurch die Lebenserwartung der Module erhöht wird, zudem behindert er die Ausbreitung von Schock- oder Druckwellen in der Kühlflüssigkeit.

Je grösser die Ausdehnung der plattenförmigen Module ist, desto grösser sind bei gleichbleibender Moduldicke die Schwingungsamplituden und umso gravierender sind deren Auswirkungen. Mit dem erfindungsgemässen Schwingungsdämpfer ist es nun auch möglich, Module einzusetzen, welche eine Ausdehnung von mehr als 0.05 m² aufweisen.

In einer ersten Ausführungsform sind im Schwingungsdämpfer Kanäle vorgesehen, durch welche die Kühlflüssigkeit zirkulieren kann. Eine schnellere Abkühlung des Strombegrenzers auf die Temperatur der Kühlflüssigkeit sowie eine homogenere Temperaturverteilung werden dadurch ermöglicht.

Gemäss einer weiteren Ausführungsform ist der Schwingungsdämpfer ein poröser Körper, beispielsweise in Form von aus Zellstoff hergestellten Pressplatten, deren Poren mit Kühlflüssigkeit gefüllt sind. Dieser Schwingungsdämpfer kann auch in mehrere Teilkörper zerfallen, welche über die Oberfläche der Module verteilt angeordnet sind. Alternativ dazu kann der Schwingungsdämpfer auch eine Schüttung sein aus kleinen Teilchen, vorzugsweise Sandpartikeln, welche sich auch nachträglich zwischen die Module einfüllen lassen.

Der Schwingungsdämpfer hat vorzugsweise eine Dielektrizitätskonstante, welche in etwa derjenigen der Kühlflüssigkeit entspricht. Ist nämlich die Dielektrizitätskonstante des Schwingungsdämpfers viel grösser als diejenige der Kühlflüssigkeit, so kann es in Letzterer zu einer Überhöhung des elektrischen Feldes kommen.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen die beiden Figuren je einen Querschnitt durch einen in eine Kühlflüssigkeit eingetauchten resistiven Strombegrenzer nach der Erfindung. Dieser weist einen zwischen die Module eingebrachten Schwingungsdämpfer auf, und zwar in
Fig.1 in Form von eingefüllten Sandpartikeln oder
Fig.2 in Form von eingeklemmten Dämpfungskörpern.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

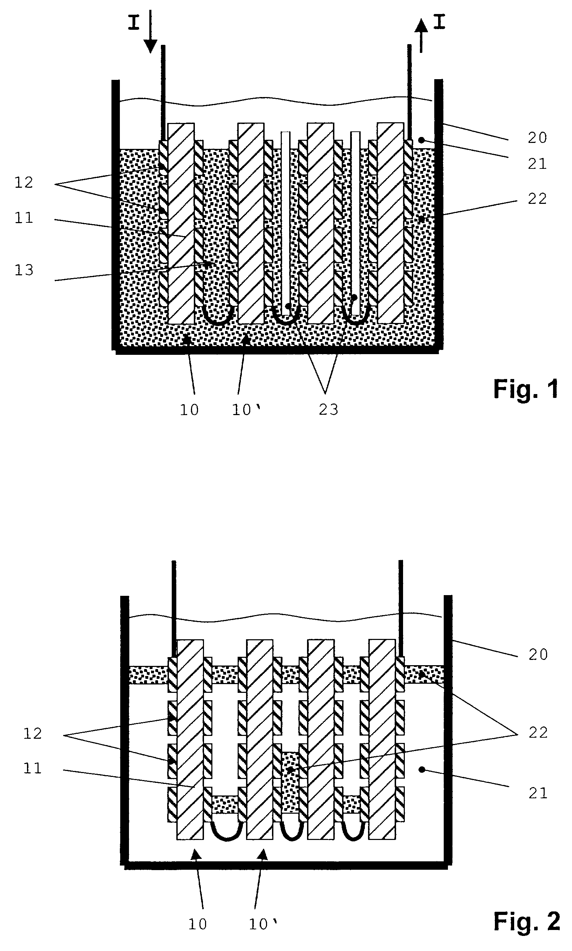

Der in den Figuren 1 und 2 dargestellte Strombegrenzer besteht aus 4 plattenförmigen Modulen 10,10', welche elektrisch in Serie geschaltet sind und von einem Strom I durchflossen werden. Jedes Modul 10 umfasst einen Isolator 11 und Leiterbahnen 12, welche beispielsweise in Form eines fortlaufenden oder spiralförmigen Mäanders beidseitig auf den Isolator 11 aufgebracht sind. Die Leiterbahnen bestehen aus einem Leiterverbund aus einem Supraleiter und einem Normalleiter, welcher mit dem Supraleiter flächenhaft verbunden ist und einen elektrischen Bypass für diesen darstellt. Der Isolator 11 fungiert auch als Träger und ist beispielsweise auf dem Boden eines den Strombegrenzer umgebenden Kryostaten 20 abgestützt. Die Module 10,10' sind nebeneinander angeordnet und bilden Zwischenräume 13, welche von einer Kühlflüssigkeit 21 ausgefüllt werden. Letztere umfasst vorzugsweise flüssigen Stickstoff LN₂ und kühlt die Vorrichtung auf eine Betriebstemperatur T_{B} von 77 K.

In Fig.1 ist der Kryostat 20 fast bis zum oberen Rand der Module 10,10' mit einem Schwingungsdämpfer 22 in Form einer Schüttung oder Füllung aus kleinen Partikeln gefüllt. Diese Schüttung bildet einen Dämpfer insbesondere für die transversalen Schwingungen der Module 10,10' senkrecht zu deren Ausdehnung, d.h. für Vibrationen in der Schnittebene der Fig.1. Die Teilchen können auch nachträglich in eine bestehende Anordnung einfach eingefüllt werden, sofern die Module 10,10' senkrecht stehen. Es ist dabei nicht notwendig, den gesamten Zwischenraum 13 zu füllen, für eine ausreichende Dämpfung genügt auch eine Schüttung, welche beispielsweise bis zur Mitte der Module 10,10' reicht. Die spezifische Dichte der Teilchen liegt vorzugsweise über der Dichte der Kühlflüssigkeit 21 (welche beispielsweise für LN₂ 0.8 g/cm³ beträgt). Besonders geeignet sind Sand (SiO₂), keramische Pulver wie Aluminiumoxid (Al₂O₃), Zirkon (ZrSiO₄), Mullit (Al₂O₃)₃(SiO₂)₂, Mica, Silicate, oder auch Polymerflocken aus PET oder Nylonpartikel oder Mischungen der genannten Partikel. Ebenso denkbar sind keramische Pulver mit einem Polymerüberzug. Damit lassen sich deren dielektrische und wärmeleitende Eigenschaften steuern, zudem wird die Form der Partikel abgerundet und einer Abnützung der Module durch Reibung an den Partikeln vorgebeugt.

In Fig.2 ist eine alternative Ausführungsform dargestellt, bei welcher ein fester Körper mit einer bei Betriebstemperatur T_{B} ausreichenden inneren Reibung als Schwingungsdämpfer 22 eingesetzt wird. Letzterer berührt beide Module, d.h. seine Breite entspricht dem seitlichen Abstand der Module 10,10'. Der Körper umfasst beispielsweise aus Glasfasern oder Zellstoff hergestellte Pressplatten (wie beispielsweise Karton oder Pressboard), welche nicht imprägniert sind, d.h. nicht mit einem Polymerharz getränkt wurden, so dass die Kühlflüssigkeit 21 deren Poren füllt. Der Schwingungsdämpfer 22 kann mehrere Teilkörper umfassen, welche an bestimmten Stellen zwischen den Modulen 10,10' angebracht sind, derart dass eine optimale Vibrationsdämpfung erzielt wird. Die Teilkörper der Fig.2 sind zwischen den Modulen 10,10' eingeklemmt und werden deshalb bereits beim Aufbau der Vorrichtung positioniert. Auch seitlich zwischen den äussersten Modulen und der Seitenwand des Kryostaten 20 können derartige Schwingungsdämpfer vorgesehen sein.

Sofern er nicht in kleine Teilkörper zerfällt, sind in dem Schwingungsdämpfer 22 vorteilhafterweise Kanäle 23 für die Kühlflüssigkeit 21 vorgesehen. Diese Kanäle 23 verbinden das Innere des Schwingungsdämpfers 22 mit einem schwingungsdämpferfreien Kühlmittelreservoir. Der Übersicht halber sind in Fig.1 nur zwei derartige Kanäle 23 eingezeichnet, sie werden durch zylindrische Rohre mit kleinen seitlichen Öffnungen realisiert. Die Verbindung zum Kühlmittelreservoir ermöglicht insbesondere eine Beschleunigung der bei der Inbetriebnahme erfolgenden Abkühlung von Raumtemperatur auf Betriebstemperatur T_{B} und gewährleistet im Betrieb eine homogenere Temperaturverteilung. Zusätzlich kann die Kühlflüssigkeit 21 mittels einer Pumpe in den Kanälen 23 in Zirkulation versetzt werden.

Um zu vermeiden, dass zwischen den Modulen, welche sich im Fehlerfall auf verschiedenem elektrischem Potential befinden, unverhältnismässig grosse Abstände vorgesehen werden müssen, darf der erfindungsgemässe Schwingungsdämpfer die elektrische Durchschlagsfestigkeit der Anordnung nicht zu stark beeinträchtigen. Die Dielektrizitätskonstante (ε) des Schwingungsdämpfers sollte nicht viel höher sein als diejenige der Kühlflüssigkeit (z.B. ε(LN₂) = 1.43), da ansonsten sogenannte Feldüberhöhungen in der Kühlflüssigkeit mit einer erhöhten Neigung zu elektrischen Durchbrüchen auftreten können.

Das eingangs geschilderte Problem der Rissbildung ist nicht auf einen bestimmten Hochtemperatursupraleiter-Typ und/oder ein bestimmtes Verfahren zu seiner Herstellung beschränkt. In Strombegrenzeranwendungen eingesetzt wird beispielsweise schmelzprozessiertes Bi₂Sr₂CaCu₂O₈ als polykristallines Bulkmaterial mit Schichtdicken vorzugsweise zwischen 50 und 1000 µm. Damit lassen sich Module präparieren mir einer Ausdehnung in der Ebene senkrecht zur Schnittebene der Fig.1 von bis zu einigen 0.1 m². Allerdings sind grössere Module gegenüber Vibrationen stärker gefährdet, und dies trotz des Einsatzes von Faserverbundwerkstoffen oder von elektrisch isolierten metallischen Substraten als Träger. Die Module weisen untereinander einen seitlichen Abstand von 2 - 20 mm auf.

Sofern die spezifische Wärme des erfindungsgemäss eingesetzten Schwingungsdämpfers grösser ist als diejenige des Kühlmediums, hat Ersterer weiter eine Funktion als Wärmezwischenspeicher. Die bei einer abrupten Erwärmung des Supraleiters erzeugte Wärme wird zumindest teilweise zuerst vom Schwingungsdämpfer aufgenommen und erst nachher an die Kühlflüssigkeit weitergegeben. Somit wird weniger Energie pro Zeiteinheit der Kühlflüssigkeit zugeführt, so dass entsprechend deren Verdampfungsrate sinkt.

Die vorgängig am Beispiel eines resistiven supraleitenden Strombegrenzers erläuterte Erfindung ist keineswegs auf planare Modulgeometrien gebunden. Der erfindungsgemässe Einsatz eines Schwingungsdämpfers ist auch bei anderen Bauteilen der Supraleitungstechnik, insbesondere zwischen den Wicklungen eines Transformators, denkbar. Weniger mechanische Beschädigungen sind die Folge, und dementsprechend ein verringerter Austauschbedarf und eine höhere Verfügbarkeit.

### BEZUGSZEICHENLISTE

- 10: Modul
- 11: Isolator
- 12: Leiterbahn
- 13: Zwischenraum
- 20: Kryostat
- 21: Kühlflüssigkeit
- 22: Schwingungsdämpfer
- 23: Kanal

## Patentansprüche

1. Resistiver Strombegrenzer, umfassend mindestens zwei plattenförmige Module (10,10') mit je einem Isolator (11) und einer Hochtemperatursupraleitermaterial aufweisenden Leiterbahn (12), wobei die mindestens zwei Module (10,10') nebeneinander angeordnet sind und einen Zwischenraum (13) bilden,
**dadurch gekennzeichnet, dass** in dem Zwischenraum (13) ein mit beiden Modulen (10,10') stoffschlüssig verbundener, poröser, elektrisch isolierender Schwingungsdämpfer (22) zur Dämpfung von Schwingungen der Module (10,10') vorgesehen ist.

2. Strombegrenzer nach Anspruch 1, **dadurch gekennzeichnet, dass** die Module (10,10') eine Ausdehnung von mindestens 0.05 m² aufweisen.

3. Strombegrenzer nach Anspruch 1, **dadurch gekennzeichnet, dass** im Schwingungsdämpfer (22) Kanäle (23) vorgesehen sind, in welchen eine Kühlflüssigkeit (21) zirkulieren kann.

4. Strombegrenzer nach einem der Ansprüche 1 bis 3, **dadurch gekennzeichnet, dass** der Schwingungsdämpfer (22) einen zwischen den Modulen (10,10') eingeklemmten Körper umfasst.

5. Strombegrenzer nach Anspruch 4, **dadurch gekennzeichnet, dass** der Schwingungsdämpfer (22) mehrere im Zwischenraum (13) verteilt angeordnete Teilkörper umfasst.

6. Strombegrenzer nach einem der Ansprüche 1 bis 3, **dadurch gekennzeichnet, dass** der Schwingungsdämpfer (22) eine in den Zwischenraum (13) eingefüllte Schüttung von Teilchen umfasst.

7. Strombegrenzer nach Anspruch 6, **dadurch gekennzeichnet, dass** der Schwingungsdämpfer (20) Sandpartikel umfasst.

8. Strombegrenzer nach einem der Ansprüche 1 bis 7, wobei die Module (10,10') in eine den porösen Schwingungsdämpfer (20) durchdringende Kühlflüssigkeit (22) eingetaucht sind, **dadurch gekennzeichnet, dass** die Dielektrizitätskonstante des Schwingungsdämpfers (20) im wesentlichen gleich demjenigen der Kühlflüssigkeit (22) ist.
